# EUROPEAN PATENT APPLICATION

(11) **EP 4 574 900 A1**
(43) Date of publication of application: **25.06.2025**
(21) Application number: 23864678.0
(22) Date of filing: 12.09.2023
(51) Int. Cl.: C08L 63/02, C08L 63/00, C08G 59/50, H01L 21/56, H01L 23/28

(54) **RESIN COMPOSITION, METHOD FOR PREPARING SAME, AND USE THEREOF**

(30) Priority: 15.09.2022 CN 202211120011
(71) Applicant: Huawei Technologies Co., Ltd., Shenzhen, Guangdong 518129 (CN)
(72) Inventor: XU, Weina, Shenzhen, Guangdong 518129 (CN); LIU, Chengjie, Shenzhen, Guangdong 518129 (CN); CHUANG, Teyi, Shenzhen, Guangdong 518129 (CN)
(74) Representative: Goddar, Heinz J.
(86) International application number: PCT/CN2023/118146
(87) International publication number: WO 2024/055946

(57) **Abstract**

Embodiments of this application provide a resin composition and a preparation method and an application thereof. The resin composition includes epoxy resin, a curing agent, a curing accelerator, and an auxiliary agent, and the auxiliary agent includes a colorant and a toughening agent, where a total mass fraction of particles with particle sizes greater than 300 nm in the resin composition is less than or equal to 0.1 wt%. The resin composition has a good narrow-gap filling capability, and can ensure that a cured product of the resin composition has a good filling effect and has few air holes and particle impurities.

## Description

This application claims priority to Chinese Patent Application No. 202211120011.4, filed with the China National Intellectual Property Administration on September 15, 2022 and entitled "RESIN COMPOSITION AND PREPARATION METHOD AND APPLICATION THEREOF", which is incorporated herein by reference in its entirety.

### TECHNICAL FIELD

This application relates to the field of packaging technologies, and in particular, to a resin composition and a preparation method and an application thereof.

### BACKGROUND

An electronic device gradually becomes thinner and smaller, and a display component of the electronic device gradually moves toward a narrower bezel and becomes thinner. Based on this, a COF (Chip on Film, chip on film) packaging technology emerges. The COF packaging technology is currently one of mainstream packaging manners of a driver chip of a display, allowing a chip to be directly packaged on a flexible substrate and to be moved, through folding, to a position below a display connected to the package. Therefore, the COF packaging technology provides advantages such as high assembly density, high flexibility, a small size, and a light weight, and may enable an electronic device to have a relatively narrow bezel.

An underfill filled in a gap between the bottom of the chip and the flexible substrate is one of key materials in the COF packaging technology. Currently, a commonly used COF underfill is an epoxy resin composition, but the epoxy resin composition usually includes a filler of a large particle size. This is not conducive to filling of a relatively narrow gap, is likely to result in an air hole, and reduces flexibility of a system. In addition, an epoxy resin composition that does not include a filler is usually used with another additive, and large particles also exist in the system. This is not conducive to filling of a relatively narrow gap either.

Therefore, there is a need to provide a COF underfill with few particles and high reliability in filling, for practical use in filling a narrow gap of a COF chip.

### SUMMARY

In view of this, embodiments of this application provide a resin composition, to resolve a problem that an existing COF underfill is not applicable to narrow-gap filling because particles in the COF underfill are not strictly controlled.

A first aspect of embodiments of this application provides a resin composition, where the resin composition includes epoxy resin, a curing agent, a curing accelerator, and an auxiliary agent, the auxiliary agent includes a colorant and a toughening agent, and a total mass fraction of particles with particle sizes greater than 300 nm in the resin composition is less than or equal to 0.1 wt%.

In the resin composition provided in this application, content of particles with particle sizes greater than 1 µm is relatively low. This helps the composition smoothly fill a relatively narrow gap between a COF chip and a flexible substrate, and can ensure that there are few air holes and particles, to match development of a current highly integrated chip.

In an implementation of this application, a viscosity of the resin composition at a room temperature ranges from 0.3 Pa·s to 1 Pa·s. The resin composition has a relatively low viscosity at a room temperature. This helps ensure that the resin composition has good fluidity, and can smoothly fill all bottom gaps, thereby improving bonding firmness of the chip on the flexible substrate, and ensuring reliability in a transportation and long-term use process of a packaged chip.

In an implementation of this application, a total mass fraction of particles with particle sizes between 100 nm and 300 nm in the resin composition is within a range of 0.2%-4%. The existence of an appropriate amount of these small particles helps improve flexibility of a cured product of the resin composition, and improve packaging reliability.

In an implementation of this application, the resin composition does not include an inorganic filler. This helps the resin composition keep a relatively low viscosity, facilitating narrow-gap filling. In addition, the resin composition is not prone to aggregation of a filler and the like.

In an implementation of this application, a viscosity increase rate of the resin composition left to stand at the room temperature and a humidity of 45% for 24 hours is less than 200%. This helps ensure that the resin composition has a relatively long operation process time window; and no obvious viscosity increase occurs in an application process of the resin composition.

In an implementation of this application, a mass percentage of the epoxy resin in the resin composition ranges from 30% to 50%. An appropriate amount of the epoxy resin helps the resin composition have a relatively low viscosity and a wider process window, and ensures that a cured product of the resin composition has an appropriate mechanical strength.

In an implementation of this application, a mass percentage of the curing agent in the resin composition ranges from 40% to 65%. An appropriate amount of the curing agent helps ensure that the epoxy resin is fully cured and has a suitable curing rate and the like.

In an implementation of this application, a mass percentage of the curing accelerator in the resin composition ranges from 0.2% to 10%. The existence of an appropriate amount of the curing accelerator may increase a curing rate of the resin composition, and make the resin composition have an appropriate quantity of small particles with particle sizes between 100 nm and 300 nm.

In an implementation of this application, a mass percentage of the colorant in the resin composition does not exceed 1%, and a mass percentage of the toughening agent in the resin composition does not exceed 15%.

In an implementation of this application, the colorant includes one or more of carbon black, carbon microspheres, graphene, and an organic dye. These colorants help confirm a dispensing effect of the resin composition.

In an implementation of this application, the resin composition further includes an ion trapping agent whose mass percentage does not exceed 2%.

A second aspect of embodiments of this application provides a preparation method of a resin composition, including the following steps:
first dispersing an auxiliary agent and a curing accelerator in epoxy resin, and then adding a curing agent to obtain a resin composition, where the auxiliary agent includes a colorant and a toughening agent, and a total mass fraction of particles with particle sizes greater than 300 nm in the resin composition is less than or equal to 0.1 wt%.

The preparation method of the resin composition is simple and easy to operate, content of a particulate matter of a large particle size in the obtained resin composition is low, a viscosity of the composition is relatively low, and the resin composition is more suitable for narrow-gap filling.

A third aspect of embodiments of this application provides an application of the foregoing resin composition in sealed packaging of an electronic component.

A fourth aspect of embodiments of this application provides a packaging material, used for sealed packaging of an electronic component. The packaging material includes the resin composition according to the first aspect of embodiments of this application and/or a cured product of the resin composition.

A fifth aspect of embodiments of this application provides a cured product. The cured product includes a cured product of the resin composition according to the first aspect of embodiments of this application, or the cured product is obtained by curing a resin composition prepared by using the preparation method according to the second aspect of embodiments of this application. The cured product of the resin composition has a good narrow-gap filling effect, and has few air holes and particle impurities.

A sixth aspect of embodiments of this application provides a package, where the package includes the cured product according to the fifth aspect of embodiments of this application. The package prepared by using the foregoing cured product has relatively high service reliability.

A seventh aspect of embodiments of this application provides a package, where the package includes a substrate and a chip disposed on the substrate, a plurality of solder bumps are provided on a surface that is of the chip and that faces a side of the substrate, an underfill layer is disposed between the solder bumps, and the underfill layer includes the cured product according to the fifth aspect of embodiments of this application. In this case, the package may be specifically a COF packaged chip, and may be applied to a small-sized, light, and thin terminal device, and enable the terminal device to have a narrow bezel.

An eighth aspect of embodiments of this application provides a display, where the display includes a display panel and the package according to the seventh aspect of embodiments of this application connected to the display panel. Using the foregoing package helps to make a bezel of the display relatively narrow and improve quality reliability.

A ninth aspect of embodiments of this application provides a terminal device, where the terminal device includes the package according to the sixth aspect of embodiments of this application or the display according to the eighth aspect of embodiments of this application. By using the foregoing package or display, performance of the terminal device can be improved, and market competitiveness can be improved.

### BRIEF DESCRIPTION OF DRAWINGS

FIG. 1 is a diagram of a structure of a package; and
FIG. 2 is a diagram of a structure of a display panel on which the package in FIG. 1 is installed.

### DESCRIPTION OF EMBODIMENTS

The following describes technical solutions in this application with reference to accompanying drawings in embodiments of this application.

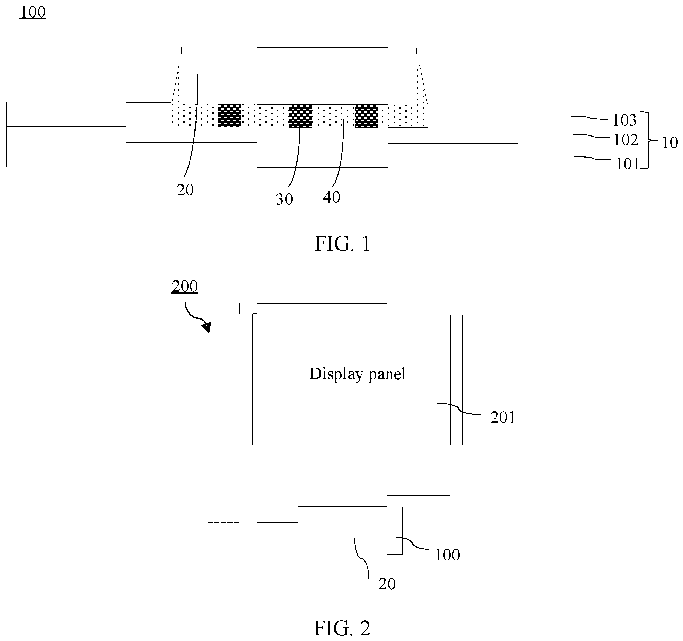

FIG. 1 is a diagram of a structure of a package according to an embodiment of this application. The package 100 includes a substrate 10 and an electronic component 20 disposed on a surface on a side of the substrate 10. The electronic component 20 may be one or more of a chip, a transistor (such as a diode or a triode), an LED (Light Emitting Diode), a resistor-capacitor-inductor element (such as a resistor, a capacitor, or an inductor), or the like. In this embodiment of this application, an example in which the electronic component 20 is a chip is used for specific description. A surface that is of the chip 20 and that faces the substrate 10 may be provided with a plurality of solder bumps 30 (for example, the solder bumps are gold), and the chip 20 may be attached to the surface of the substrate 10 by remelting the solder bumps 30. In some implementations, an underfill layer 40 is further disposed in a gap between the solder bumps 30, to fill space between the chip 20 and the substrate 10, thereby achieving a more stable connection effect. The underfill layer 40 may be formed by point-coating and curing liquid glue.

When the electronic component 20 is a chip and the substrate 10 is a flexible printed circuit board (Flexible Printed Circuit, FPC for short), the package 100 may also be referred to as a "COF packaged chip", that is, a chip on a flexible substrate. In this case, the chip 20 is directly packaged on the FPC, and is placed in a flat cable of the FPC. When the COF packaged chip is connected to a display panel 201 driven by the COF packaged chip (as shown in FIG. 2), the chip 20 may be moved to a position below the display panel 201 (that is, the back of the display panel 201) through folding by using bendability of the FPC. Because space occupied by the chip is released, a terminal device using the display panel may have a relatively narrow screen bezel, especially a relatively narrow lower bezel.

With an increase of chip integration, a height of the solder bump 30 between the chip 20 and the substrate 10 becomes smaller, and the gap filled by the underfill layer 40 becomes narrower accordingly. This requires that a COF underfill should have a relatively low viscosity, a relatively small quantity of particles, and the like, to meet high fluidity and a sufficient process operation time window to ensure that the gap is fully filled. However, because an existing COF underfill usually cannot meet these requirements, it is difficult to actually use the COF underfill to seal a narrow gap whose height is less than 15 µm. In view of this, an embodiment of this application provides a resin composition. The resin composition may be used to form the underfill layer 40 with good quality through coating and curing the resin composition, to fully fill a narrow gap whose height is less than 15 µm.

Specifically, the resin composition provided in this embodiment of this application includes epoxy resin, a curing agent, a curing accelerator, and an auxiliary agent. The auxiliary agent includes a colorant and a toughening agent. A total mass fraction of particles with particle sizes greater than 300 nm in the resin composition is less than or equal to 0.1 wt%.

In the resin composition provided in this application, the "particle" comes from a particle component in the resin composition, for example, may come from the auxiliary agent or a combination of the auxiliary agent and the curing accelerator. Content of particles with particle sizes greater than 0.3 µm in the resin composition is controlled to be relatively low. This helps the composition to smoothly fill a relatively narrow gap between the COF chip and the flexible substrate, and can ensure that there are relatively few air holes and particle impurities, to match development of a current highly integrated chip, and fill a narrow gap whose height is less than 15 µm. In addition, the existence of the toughening agent can improve flexibility of a cured product of the resin composition, and ensure high reliability; and the existence of the colorant can deepen a color of the resin composition, improve application convenience of the resin composition, and facilitate observation of an application effect.

In an implementation of this application, a viscosity of the resin composition at a room temperature ranges from 0.3 Pa·s to 1 Pa·s. The resin composition has a relatively low viscosity at a room temperature. This helps ensure that the resin composition has good fluidity and high filling performance, and facilitates smooth flow to allow the resin composition to enter a relatively narrow gap and fully fill all bottom gaps, thereby improving bonding firmness of the chip on the flexible substrate, and ensuring reliability in a transportation and long-term use process of a packaged chip. In this application, the term "room temperature" may be specifically any temperature of 20°C-30°C, for example, 20°C, 22°C, 25°C, 28°C, or 30°C, and 25°C is relatively common.

In this application, the total mass fraction of the particles with the particle sizes greater than 300 nm in the resin composition may be less than or equal to 0.05 wt%, or less than or equal to 0.01 wt%, or even 0 (in this case, the resin composition does not include particles with particle sizes greater than 300 nm). When content of the particles with particle sizes greater than 300 nm is 0, a filling capability of the resin composition is better.

In some implementations of this application, a total mass fraction of particles with particle sizes greater than 0.1 µm in the resin composition is less than or equal to 0.1 wt%. In this case, the total mass fraction of the particles with the particle sizes greater than 0.1 µm in the resin composition may be less than or equal to 0.05 wt%, or less than or equal to 0.02 wt%, or even 0. In this case, the resin composition has a better filling capability, and can seal a narrower gap in the chip, for example, a gap whose height is less than 10 µm or less than 5 µm.

In an implementation of this application, a total mass fraction of particles with particle sizes between 100 nm and 300 nm in the resin composition is within a range of 0.2%-4%. These small particles come from at least the auxiliary agent that includes the colorant and the toughening agent. The existence of an appropriate amount of these small particles can better improve flexibility of a cured product of the resin composition, and improve packaging reliability.

In this application, the viscosity of the resin composition at the room temperature may be specifically 0.3 Pa·s, 0.4 Pa·s,0.45 Pa·s,0.5 Pa·s,0.6 Pa·s,0.65 Pa·s,0.7 Pa·s,0.8 Pa·s,0.85 Pa·s,0.9 Pa·s, or the like. In some implementations, the viscosity of the resin composition at the room temperature ranges from 0.45 Pa·s to 1 Pa·s. In this case, the resin composition has relatively good fluidity, and also helps ensure good adhesion of a cured product of the resin composition on the substrate.

In an implementation of this application, the resin composition does not include an inorganic filler. The inorganic filler includes silicon dioxide, aluminum oxide, titanium dioxide, boron nitride, aluminum titanide, silicon titanide, aluminum nitride, silicon nitride, and the like, and silicon dioxide is the most common. In a common resin composition, content of an inorganic filler is usually greater than 10%. By contrast, in this application, the resin composition that does not include an inorganic filler has a relatively low viscosity. This is more conducive to narrow-gap filling of the resin composition, the resin composition is not prone to particle aggregation; and the like. In addition, the foregoing resin composition is usually used for a COF underfill, a gap filled by the resin composition is relatively narrow (a height usually does not exceed 15 µm), and a formed underfill layer is usually relatively thin. Even if no inorganic filler is included, the underfill layer is not prone to warping.

In addition, because the resin composition does not include an inorganic filler, in an implementation of this application, the resin composition may not include a coupling agent. The coupling agent may be a silane coupling agent, a titanate coupling agent, aluminate coupling agent, or the like.

Because the resin composition does not include an inorganic filler, in an implementation of this application, content of a silicon (Si) element, content of an aluminum (Al) element, content of a titanium (Ti) element, and content of a boron (B) element in the resin composition are relatively low, for example, are all less than 0.05 wt%. In some cases, content of each of these elements may be 0. Content of these elements is extremely low. This helps reduce total ion content in the system, and helps improve packaging reliability of the resin composition.

In an implementation of this application, the resin composition does not include an organic solvent. In this way, an aftertreatment difficulty caused by addition of a solvent and a problem that bubbles are generated due to solvent volatilization in a curing process of the resin composition can be avoided.

In an implementation of this application, a viscosity increase rate of the resin composition left to stand at the room temperature and a humidity of 45% for 24 hours is less than 200%. A relatively small viscosity increase rate helps ensure that the resin composition has a relatively long operation process time window, and can keep a relatively low viscosity and high fluidity before all bottom gaps are fully filled, thereby improving bonding firmness of the chip on the flexible substrate. 24h viscosity increase rate Δη = (viscosity obtained after the resin composition is left to stand for 24h - initial viscosity)/initial viscosity × 100%. In some implementations of this application, the viscosity increase rate of the resin composition is less than 100%, for example, less than 90%. It should be noted that, during representation of the viscosity increase rate of the resin composition, a mentioned humidity value may be allowed to fluctuate to a specific extent. For example, a humidity of 45%±5% may also be considered as a humidity of 45%. "Room temperature" may be any temperature of 20°C-30°C, for example, 22°C, 25°C, or 28°C.

The resin composition in this embodiment of this application is cured when being heated. To be specific, a chemical reaction between the epoxy resin and the curing agent may occur to form a three-dimensional network polymer. The curing accelerator can promote/increase a curing reaction speed of the resin composition at a specific temperature. The resin composition is transformed into a cured product in a specific shape after being cured. In an implementation of this application, a mass percentage of the epoxy resin in the resin composition ranges from 30% to 50%. In an implementation of this application, a mass percentage of the curing agent in the resin composition ranges from 40% to 65%. An appropriate amount of the epoxy resin helps the resin composition have a relatively low viscosity and a wider process window, and ensures that a cured product of the resin composition has an appropriate mechanical strength. An appropriate amount of the curing agent helps ensure that the epoxy resin is fully cured and has a suitable curing rate and the like.

Specifically, the mass percentage of the epoxy resin in the resin composition may be 32%, 35%, 40%, 43%, 45%, 48%, 50%, or the like. The mass percentage of the curing agent in the resin composition may be 42%, 45%, 50%, 55%, 58%, 59%, 60%, 62%, 63%, 65%, or the like. In some implementations, the mass percentage of the epoxy resin in the resin composition ranges from 40% to 50%, and may further range from 42% to 50%. The mass percentage of the curing agent in the resin composition ranges from 54% to 65%, and may further range from 54% to 57% or from 59% to 65%.

In this application, the epoxy resin may include one or more of bisphenol-type epoxy resin (for example, bisphenol-A epoxy resin or bisphenol-F epoxy resin), aliphatic epoxy resin, silicon-containing epoxy resin, aromatic epoxy resin (for example, naphthalene epoxy resin, aminophenol epoxy resin, or biphenyl epoxy resin), and the like. The naphthalene epoxy resin and the aminophenol epoxy resin help make the cured product of the resin composition have a relatively high glass transition temperature, to reduce a risk of softening the cured product at a high temperature; and the aliphatic epoxy resin helps make the resin composition have a relatively low viscosity.

These types of epoxy resin may be in a liquid state or a solid state at a room temperature, but the epoxy resin in the resin composition includes at least one type of epoxy resin that is in a liquid state at a room temperature (for example, 25°C), to make the resin composition have a relatively low viscosity at the room temperature. If the epoxy resin includes epoxy resin that is in a liquid state at the room temperature and epoxy resin that is in a solid state at the room temperature, during preparation of the resin composition, the epoxy resin in a solid state needs to be dissolved in liquid resin first, and then mixed with another component. The existence of the epoxy resin that is in a solid state at the room temperature is conducive to increasing a glass transition temperature of the cured product of the resin composition.

In some implementations of this application, the curing agent is an anhydride curing agent. This type of curing agent is easier to make the resin composition have a relatively low viscosity and a relatively short curing time, and is more suitable for a COF underfill system. The resin composition in this case includes epoxy resin, an anhydride curing agent, and an auxiliary agent. In an implementation of this application, the anhydride curing agent may include one or more of methylhexahydrophthalic anhydride, methyltetrahydrophthalic anhydride, methyl nadic anhydride, hydrogenated methyl nadic anhydride, dodecenyl succinic anhydride, and terpenic anhydride, and the like, but no limitation is set thereto. Methylhexahydrophthalic anhydride helps make the resin composition have a low viscosity and high curing reaction performance, methyl nadic anhydride enables the cured product of the resin composition to have a relatively high glass transition temperature; and dodecenyl succinic anhydride and terpenic anhydride help make the cured product of the resin composition have good flexibility.

In this application, the curing accelerator is also referred to as a curing catalyst, and can increase a curing reaction speed of the resin composition at a specific temperature. In some implementations of this application, the curing accelerator includes an imidazole accelerator. The imidazole accelerator may be selected from one or more of imidazole, dimethylimidazole, 4,5-dihydroxymethyl-2-phenylimidazole, 2-ethyl-4-methylimidazole, 2,4-diamino-6-[2-(2-methyl-1-imidazolyl)ethyl]-1,3,5-triazine, 2-undecylimidazole, 1-cyanoethyl-2-ethyl-4-methylimidazole, 2-phenylimidazole, 2-phenyl-4-methylimidazole, 1-benzyl-2-methylimidazole, 1-phenyl dimethylimidazole, and the like. The imidazole curing accelerator may be powder or liquid at a room temperature.

In an implementation of this application, a mass percentage of the curing accelerator in the resin composition does not exceed 10%, to avoid a case in which film flatness of the underfill layer is affected because a curing rate of the resin composition is excessively high due to excessively high content of the curing accelerator. In some implementations, the mass percentage of the curing accelerator in the resin composition ranges from 0.2% to 10%. For example, the mass percentage is specifically 0.3%, 0.5%, 1%, 2%, 5%, or 8%. In some other implementations, the mass percentage of the curing accelerator in the resin composition ranges from 0.2% to 2.5%.

In some implementations of this application, the resin composition includes components of the following mass percentages: the epoxy resin 42%-50%, the curing agent 55%-65%, the curing accelerator 0.2%-2.5%, and an auxiliary agent. In this case, the viscosity of the resin composition at the room temperature may be within a range from 0.45 Pa·s to 1 Pa·s, and the resin composition has relatively good fluidity and narrow-gap filling performance. In addition, a cured product of the resin composition has relatively good adhesion.

In this application, the auxiliary agent includes a colorant and a toughening agent, and in some cases, the auxiliary agent further includes an ion trapping agent. It may be understood that a type of the auxiliary agent may not be limited thereto.

The colorant is mainly used to give a specific color to the resin composition, for example, to deepen the color of the composition, so that during dispensing of the resin composition, it can be determined, based on a color difference, whether a glue shape and a dispensing amount meet requirements. For example, the colorant may include one or more of carbon black, carbon microspheres, graphene, an organic dye, and the like. In an implementation of this application, a mass percentage of the colorant in the resin composition does not exceed 1%, for example, 0.01%, 0.05%, 0.1%, 0.2%, 0.5%, 0.8%, or 1%. In some implementations, the mass percentage of the colorant in the resin composition ranges from 0.1% to 2%.

The toughening agent may be used to improve flexibility of a cured product of the resin composition, so that the cured product does not break when the packaged chip is bent, thereby ensuring high reliability. In an implementation of this application, the toughening agent may include rubber, an aliphatic compound, and the like. The toughening agent may exist in a granular shape or in a long strip shape. For example, in some implementations, the toughening agent may include rubber particles, long-chain aliphatic compound particles, and the like. In an implementation of this application, a mass percentage of the toughening agent in the resin composition does not exceed 15%, for example, 0.1%, 0.5%, 1%, 2%, 5%, 8%, 10%, 12%, or 15%. In some implementations, the mass percentage of the toughening agent in the resin composition is 1%-5%.

The ion trapping agent may be used to trap ions in the resin composition, for example, halogen ions, to prevent metal migration caused because the solder bump 30 of the chip 20 is corroded by the halogen ions, and ensure high reliability in a case of a narrow gap. The ion trapping agent may include an organic ion trapping agent and/or an inorganic ion trapping agent. Generally, the inorganic ion trapping agent has a better ion trapping capability. For example, the inorganic ion trapping agent may include one or more of zirconium hydrophosphate, magnesium aluminum salt hydrate, and the like. In an implementation of this application, a mass percentage of the ion trapping agent in the resin composition does not exceed 2%, for example, is 0, 0.1%, 0.2%, 0.5%, 0.8%, 1%, 1.5%, or 2%. In some implementations, the mass percentage of the ion trapping agent in the resin composition ranges from 0.2% to 2%.

In this application, an appropriate ratio of the epoxy resin, the curing agent, the curing accelerator, the auxiliary agent, and the like helps ensure that the resin composition has a relatively low viscosity. It should be noted that, because the resin composition includes the auxiliary agent, total content of all auxiliaries should not be 0. In some cases, content of the ion trapping agent may be 0.

In an implementation of this application, the resin composition is black. The black resin composition is more conducive to visually distinguishing the resin composition from the substrate 10, the solder bump 30, and the like, and is more convenient to determine, during dispensing, whether a glue shape and a dispensing amount of the resin composition meet requirements. The color of the resin composition may be brought by an additive contained therein, especially the colorant.

An embodiment of this application further provides a preparation method of a resin composition, including the following steps:
first dispersing an auxiliary agent and a curing accelerator in epoxy resin, and then adding a curing agent and performing mixing to obtain a resin composition, where the auxiliary agent includes a colorant and a toughening agent, and a total mass fraction of particles with particle sizes greater than 300 nm in the resin composition is less than or equal to 0.1 wt%.

In the foregoing preparation method of the resin composition, the auxiliary agent and the curing accelerator that may include a particulate matter are first dispersed in the epoxy resin, where the epoxy resin may be used as a dispersion medium to implement uniform dispersion and particle size reduction of the auxiliary agent in the epoxy resin; and then the epoxy resin is mixed with another component (such as the curing agent) that does not include a particulate matter. In this way, it can be ensured that content of particles of a large particle size in the obtained resin composition is extremely low, and the resin composition is more suitable for narrow-gap filling. Dispersion treatment may be performed at a room temperature or at an appropriate high-temperature (for example, not higher than 120°C). In an implementation of this application, dispersion treatment of the auxiliary agent and the curing accelerator in the epoxy resin may be performed in a ball mill, a grinding machine (for example, a three-roll grinding machine), a sand mill, a mechanical fusion machine, a mechanical mixing apparatus, a shearing device, and the like. In other words, dispersion treatment specifically includes but is not limited to ball milling, grinding, sand milling, mechanical fusion, mechanical mixing, shearing, and the like.

In some implementations of this application, a total mass fraction of particles with particle sizes greater than 0.3 µm in the resin composition is 0. In this case, the resin composition has a better packaging effect on a narrow-gap chip. Further, a total mass fraction of particles with particle sizes greater than 0.1 µm in the resin composition is less than or equal to 0.1 wt%, or even 0.

The preparation method of the resin composition is simple and easy to operate, content of a particulate matter of a large particle size in the obtained resin composition is low, a viscosity of the composition is relatively low, and the resin composition is more suitable for narrow-gap filling.

An embodiment of this application further provides a cured product. The cured product is obtained by curing the resin composition described above in this application, or is obtained by curing a resin composition prepared by using the preparation method described above in this application. In other words, the cured product includes a cured product of the foregoing resin composition. The cured product is well distributed in a narrow gap, and has a relatively small quantity of air holes and few particle impurities.

An embodiment of this application further provides an application of the foregoing resin composition in sealed packaging of an electronic component.

Specifically, an embodiment of this application provides a packaging material, where the packaging material includes the resin composition in embodiments of this application and/or a cured product of the resin composition. The packaging material may be used for sealed packaging of an electronic component.

An embodiment of this application further provides a package, where the package includes the cured product in embodiments of this application. The package is packaged by using the resin composition provided in embodiments of this application, and has high reliability.

Specifically, refer to FIG. 1. The package 100 including the cured product may include a substrate 10 and a chip 20 disposed on the substrate 10. A plurality of solder bumps 30 (for example, solder joints) are provided on a surface that is of the chip 20 and that faces a side of the substrate 10, and an underfill layer 40 is disposed in a gap between the solder bumps 30. The underfill layer 40 includes the cured product in embodiments of this application.

The substrate 10 is usually an FPC, and the FPC generally includes a base film 101, a metal foil 102, and an ink layer 103 that are disposed in a laminated manner. In a typical FPC, a base film 101 may be specifically a polyimide (PI) film, and a metal foil 102 may be specifically a copper foil. Generally, an ink layer 103 does not completely cover the metal foil 102, and generally, the ink layer 103 is not covered on a part that is of the FPC and that is to be connected to the chip 20. The solder bump 30 of the chip 20 may be bonded with an inner pin on the FPC through thermal compression bonding, to obtain the package.

When the substrate 10 of the package is a flexible FPC, the package also correspondingly has specific flexibility. The package may also be referred to as a "COF packaged chip", and it helps enable an electronic device to have a narrow bezel and a good display effect.

An embodiment of this application further provides a display. As shown in FIG. 2, a display 200 includes a display panel 201 and a package 100 connected to the display panel 201. A connection between the package 100 and the display panel 201 may be implemented by welding an edge of a substrate 10 in the package 100 to the display panel 201, or a connection between the package 100 and the display panel 201 may be implemented by using a conductive adhesive.

When the display panel 201 and the package 100 are assembled into a display, the package 100 may be bent (for example, folded along a dashed line in FIG. 2), so that a chip 20 in the package 100 is moved to a position below the display panel 201 (that is, the back of the display panel 201) through folding. Because space occupied by the chip 20 is released, the display may have a relatively narrow screen bezel, especially a relatively narrow lower bezel.

The chip 20 in the package 100 may drive the display panel 201 to be "lighted up". The display panel 201 may be a liquid crystal display (Liquid Crystal Display, LCD), an organic light-emitting diode (Organic Light-Emitting Diodes, OLED) display, a light-emitting diode (light-emitting diode, LED) display, or another type of displayable component, including but not limited to a notch screen, a water drop screen, a bezel-less screen, a curved surface screen, or the like. In addition, the display 200 may further include a cover (not shown in the figure) covering the display panel 201.

An embodiment of this application further provides an electronic device, where the electronic device includes the package or the display in embodiments of this application.

In some implementations, the electronic device may be a terminal product such as a mobile phone, a tablet computer, a notebook computer, a television, a DVD player, a video recorder, a wearable device (for example, a smartwatch or a smart band), a portable computer, a microphone, or an in-vehicle device. In some embodiments, the electronic device may further include a housing to accommodate the package 100 or the display 200. In some other implementations, the electronic device may alternatively be various wired or wireless communications devices such as a lightning arrester, an antenna, a gateway, a remote control, a radar, an intercom, a switch, and a router, or a communications base station.

In this application, "and/or" describes an association relationship between associated objects, and indicates that three relationships may exist. For example, A and/or B may indicate that: only A exists, both A and B exist, and only B exists, where A and B may be singular or plural. In this application, "at least one" means one or more, and " a plurality of" means two or more. When content of a substance mentioned in this application does not exceed a value, for example, does not exceed 10%, it means "less than or equal to 10%".

The following further describes the technical solutions in embodiments of this application by using a plurality of embodiments.

### Embodiment 1

Preparation of a resin composition: Each raw material is weighed according to a formula in Table 1. Specifically, 40 weight parts of epoxy resin (specifically including 15 weight parts of aminophenol epoxy resin, 10 weight parts of naphthalene epoxy resin, and 15 weight parts of bisphenol-F epoxy resin) and 0.5 weight part of curing accelerator (which is specifically modified imidazole that is in a liquid state at a normal temperature, and is abbreviated as a substance a), 0.5 weight part of ion trapping agent (which is specifically zirconium hydrophosphate), 0.5 weight part of toughening agent (which is specifically rubber particles), and 0.1 weight part of colorant (which is specifically carbon black) are first mixed and then dispersed in a sand mill for 5 hours, then 59 weight parts of curing agent (specifically including 29 weight parts of methylhexahydrophthalic anhydride, 10 weight parts of terpenic anhydride, 10 weight parts of dodecenyl succinic anhydride, and 10 weight parts of methyl nadic anhydride) are added and mixed evenly to obtain the resin composition. A color of the resin composition in Embodiment 1 is black.

Specific components and content of resin compositions in Embodiment 2 to Embodiment 9, a comparative example 1, and a comparative example 2 are listed in Table 1. For a preparation process thereof, refer to Embodiment 1. In Table 1, a substance b represents an imidazole curing accelerator that is solid powder at a room temperature.

A difference between the resin composition and preparation thereof in the comparative example 1 and the resin composition and preparation thereof in Embodiment 5 lies in that: The epoxy resin, the curing agent, the curing accelerator, the ion trapping agent, the colorant, and the toughening agent are directly mixed, and grinding treatment is not first performed on the epoxy resin and an auxiliary agent such as the curing accelerator and the ion trapping agent.

The resin composition in the comparative example 2 includes only the epoxy resin, the curing agent, and the curing accelerator, and the curing accelerator is the substance a that is in a liquid state at a normal temperature, and the resin composition does not include an auxiliary agent such as the toughening agent, the colorant, or the ion trapping agent. During preparation of the resin composition in the comparative example 2, the epoxy resin, the curing agent, and the curing accelerator are directly mixed.

**Table 1 Specific composition and weight parts of resin compositions in embodiments and the comparative examples**

| | | Embod iment 1 | Embo dimen t 2 | Embo dimen t 3 | Embo dimen t 4 | Embo dimen t 5 | Embo dimen t 6 | Embo dimen t 7 | Embo diment 8 | Embo dimen t 9 | Comp arative examp le 1 | Comp arative examp le 2 |
|---|---|---|---|---|---|---|---|---|---|---|---|---|
| Epoxy resin | Aminoph enol epoxy resin | 15 | 15 | 15 | 15 | 15 | 15 | 15 | 15 | 17 | 15 | 15 |
| | Naphthale ne epoxy resin | 10 | 10 | 10 | 10 | 10 | 10 | 10 | 13 | 13 | 10 | 10 |
| | Bisphenol -F epoxy resin | 15 | 15 | 15 | 15 | 15 | 15 | 17 | 17 | 20 | 15 | 15 |
| Total weight parts of resin | | 40 | 40 | 40 | 40 | 40 | 40 | 42 | 45 | 50 | 40 | 40 |
| Curing agent | Methylhe xahydrop hthalic anhydride | 28.4 | 25.4 | 27 | 28 | 26.5 | 26.5 | 24.5 | 23.5 | 20.5 | 26.5 | 26.5 |
| | Terpenic anhydride | 10 | 10 | 10 | 10 | 10 | 10 | 10 | 9 | 8 | 10 | 10 |
| | Dodeceny l succinic anhydride | 10 | 10 | 10 | 10 | 10 | 10 | 10 | 9 | 8 | 10 | 10 |
| | Methyl nadic anhydride | 10 | 10 | 10 | 10 | 10 | 10 | 10 | 10 | 10 | 10 | 10 |
| Total weight parts of the curing agent | | 58.4 | 55.4 | 57 | 58 | 56.5 | 56.5 | 54.5 | 51.5 | 46.5 | 56.5 | 56.5 |
| Curing accelerato r | Substance a | 0.5 | 2 | 0.5 | 0.5 | 0.5 | | | | | 0.5 | 0.5 |
| | Substance b | | | | | | 0.5 | 0.5 | 0.5 | 0.5 | | |
| Ion trapping agent | Zirconiu m hydropho sphate | 0.5 | 0.5 | | 0.5 | 0.5 | 0.5 | 0.5 | 0.5 | 0.5 | 0.5 | |
| Toughenin g agent | Rubber particles | 0.5 | 2 | 2 | 0.5 | 2 | 2 | 2 | 2 | 2 | 2 | |
| Colorant | Carbon black | 0.1 | 0.1 | 0.5 | 0.5 | 0.5 | 0.5 | 0.5 | 0.5 | 0.5 | 0.5 | |

Evaluation of the resin compositions in embodiments and the comparative examples is as follows:
(1) A viscosity of each resin composition is measured by using a rheometer at a room temperature (25°C), specifically at a shear rate of 5 reciprocal seconds.
(2) Viscosity measurement is performed on each resin composition after the resin composition is left to stand at the room temperature (25°C) and a humidity of 45% for 24 hours, to obtain a 24h viscosity increase rate. 24h viscosity increase rate = (viscosity after 24h - initial viscosity)/initial viscosity × 100%.
(3) Content of particles with particle sizes greater than 300 nm: Each resin composition is filtered by using a nylon filter membrane with a pore size of 300 nm. Then the filter membrane is rinsed with a solvent, a filtered product is dried, and a mass of a dry substance remaining on a surface of the filter membrane is weighed. A proportion of the mass of the dry substance to a mass of the resin composition measured before filtering is used as a mass percentage of particles with particle sizes greater than 300 nm.
   In addition, content of particles with particle sizes between 100 nm and 300 nm: After each resin composition is filtered by using the nylon filter membrane with the pore size of 300 nm, secondary filtration is performed on obtained filtrate by using a nylon filter membrane with a pore size of 100 nm, a substance remaining on the filter membrane with a pore size of 100 nm is rinsed with propane, and a dried remaining substance is weighed. A proportion of a mass of the dried substance to the mass of the resin composition measured before filtering is used as a mass percentage of particles with particle sizes between 100 nm and 300 nm.
(4) Verification of a narrow-gap filling performance: Three types of driver chips (with 45 chips per type) with a size of 15 mm × 1 mm are customized, and solder bump heights of the driver chips are 15 µm, 10 µm, and 5 µm. Each resin composition is applied to gaps between bumps through dispensing by using a dispenser. A dispensing amount for each chip is 4 mg of each resin composition. After dispensing is completed, the resin compositions are cured at 130°C for 2 h. Then, cured products are observed for air holes by using a 200x microscope, and the cured products are observed for particle impurities by using a 500x microscope. In a single chip, if a quantity of particle impurities or a quantity of air holes is less than 1, narrow-gap filling performance is excellent; if a quantity of particle impurities or a quantity of air holes is within 1 to 3, narrow-gap filling performance is qualified; or if a quantity of particle impurities or a quantity of air holes is greater than 3, narrow-gap filling performance is poor.
(5) Verification of a peeling force test: A 90-degree peeling force test is performed on a chip in (4) on which dispensing and curing have been performed and whose solder bump height is 15 µm by using a pulling force tester. If a peeling force is less than 300 gf, a test result is poor; if a peeling force is within 300 gf to 400 gf, a test result is qualified; or if a peeling force is greater than 400 gf, a test result is excellent.
(6) High-pressure accelerated aging test: 45 chips in (4) on which dispensing has been performed and whose bump heights are 15 µm are placed at a temperature of 130°C, a humidity of 85%, and a pressure of 2 atmospheres for 96 hours. Then, a test on circuit continuity is performed for the chips. If no chip has poor circuit continuity, a test result is marked as qualified; or if one or more chips have poor circuit continuity, a test result is marked as unqualified.
(7) Temperature and humidity test: The 45 chips in (4) on which dispensing has been performed and whose bump heights are 15 µm are placed at a temperature of 85°C and a humidity of 85% for 1000 hours. Then, a test on circuit continuity is performed for the chips. If no chip has poor circuit continuity, a test result is marked as qualified; or if one or more chips have poor circuit continuity, a test result is marked as unqualified.

Table 2 below summarizes evaluation results of the resin compositions in embodiments and the comparative examples.

**Table 2**

| Detection item | | Embod iment 1 | Embo dimen t 2 | Embo dimen t 3 | Embo dimen t 4 | Embo diment 5 | Embo dimen t 6 | Embo dimen t 7 | Embo dimen t 8 | Embo diment 9 | Comp arative examp le 1 | Comp arative examp le 2 |
|---|---|---|---|---|---|---|---|---|---|---|---|---|
| Viscosity (Pa·s) at a room temperature | | 0.3 | 0.4 | 0.6 | 0.5 | 0.6 | 0.65 | 0.7 | 0.8 | 1.0 | 0.3 | 0.3 |
| 24h viscosity increase rate (%) | | 40 | 57 | 60 | 88 | 58 | 57 | 80 | 75 | 88 | 60 | 70 |
| Content (wt%) of particles with particle sizes greater than 300 nm | | 0.07 | 0.07 | 0.10 | 0.09 | 0.08 | 0.10 | 0.09 | 0.09 | 0.09 | 2.7 | 0.01 |
| The particle size is between 100 nm and 300 nm | | 1.9 | 2.40 | 2.35 | 1.4 | 2.9 | 3.40 | 3.40 | 3.40 | 3.40 | 0.28 | 0.01 |
| Particle content (wt%) | | | | | | | | | | | | |
| 15 µm narrow-gap filling performan ce | Air hole | Excelle nt | Excell ent | Excell ent | Excell ent | Excell ent | Excell ent | Excell ent | Excell ent | Excell ent | Qualif ied | Excell ent |
| | Particle impurity | Excelle nt | Excell ent | Excell ent | Excell ent | Excell ent | Excell ent | Excell ent | Excell ent | Excell ent | Poor | Excell ent |
| 10 µm narrow-gap filling performan ce | Air hole | Excelle nt | Excell ent | Excell ent | Excell ent | Excell ent | Qualif ied | Excell ent | Excell ent | Excell ent | Poor | Excell ent |
| | Particle impurity | Excelle nt | Qualif ied | Excell ent | Excell ent | Excell ent | Qualif ied | Excell ent | Excell ent | Excell ent | Poor | Excell ent |
| 5 µm narrow-gap filling performan ce | Air hole | Excelle nt | Qualif ied | Excell ent | Excell ent | Excell ent | Qualif ied | Qualif ied | Qualif ied | Qualif ied | Poor | Excell ent |
| | Particle impurity | Excelle nt | Qualif ied | Qualif ied | Excell ent | Excell ent | Excell ent | Excell ent | Excell ent | Qualif ied | Poor | Excell ent |
| Peeling force | | Excelle nt | Excell ent | Excell ent | Excell ent | Excell ent | Excell ent | Excell ent | Excell ent | Excell ent | Qualif ied | Poor |
| High-pressure accelerated aging test | | Qualified | Qualified | Qualified | Qualified | Qualified | Qualified | Qualified | Qualified | Qualified | Qualified | Unqualified |
| Temperature and humidity test | | Qualifi ed | Qualif ied | Qualif ied | Qualif ied | Qualif ied | Qualif ied | Qualif ied | Qualif ied | Qualif ied | Qualif ied | Unqua lified |

By comparing Embodiment 5 and the comparative example 1 in which a same epoxy resin system, a same curing agent system, and a same auxiliary agent system are used, it can be learned from Table 2 that, content of particles with particle sizes greater than 300 nm in the resin composition in Embodiment 5 of this application is lower than that in the comparative example 1. The resin composition shows an obvious advantage in performance of filling a narrow gap in a chip, especially in filling a narrower gap with a height of 10 µm or 5 µm; and the resin composition in Embodiment 5 shows a better narrow-gap filling capability, and has no air hole or visible particle impurity. In addition, by comparing the comparative example 2 and Embodiment 1 to Embodiment 6 in this application in which a same epoxy resin system is used but no auxiliary agent is used, although content of particles with particle sizes greater than 300 nm in the resin composition in the comparative example 2 is also relatively low, the resin composition does not include an auxiliary agent or a particle-like curing accelerator raw material, and content of particles of a small particle size in the system is almost considered as 0. In this case, in reliability test methods such as a peeling force test and a high-pressure accelerated aging test, test results of a cured product of the resin composition in the comparative example 2 are obviously inferior to those in Embodiment 1 to Embodiment 6 in this application.

In addition, it can be learned by comparing Embodiment 7 to Embodiment 9 with Embodiment 6 that, when composition of the epoxy resin changes, the resin composition in embodiments of this application may also show a relatively low viscosity and relatively low content of particles of a large particle size, thereby showing a relatively good narrow-gap filling capability, and a cured product shows a strong peeling force and good quality reliability.

## Claims

1. A resin composition, wherein the resin composition comprises epoxy resin, a curing agent, a curing accelerator, and an auxiliary agent, the auxiliary agent comprises a colorant and a toughening agent, and a total mass fraction of particles with particle sizes greater than 300 nm in the resin composition is less than or equal to 0.1 wt%.

2. The resin composition according to claim 1, wherein a viscosity of the resin composition at a room temperature ranges from 0.3 Pa·s to 1 Pa·s.

3. The resin composition according to claim 1 or 2, wherein a total mass fraction of particles with particle sizes between 100 nm and 300 nm in the resin composition is within a range of 0.2%-4%.

4. The resin composition according to any one of claims 1 to 3, wherein the resin composition does not comprise an inorganic filler.

5. The resin composition according to any one of claims 1 to 4, wherein a viscosity increase rate of the resin composition left to stand at the room temperature and a humidity of 45% for 24 hours is less than 200%.

6. The resin composition according to any one of claims 1 to 5, wherein a mass percentage of the epoxy resin in the resin composition ranges from 30% to 50%.

7. The resin composition according to any one of claims 1 to 6, wherein a mass percentage of the curing agent in the resin composition ranges from 40% to 65%.

8. The resin composition according to any one of claims 1 to 7, wherein a mass percentage of the curing accelerator in the resin composition ranges from 0.2% to 10%.

9. The resin composition according to any one of claims 1 to 8, wherein the curing accelerator comprises an imidazole accelerator.

10. The resin composition according to any one of claims 1 to 9, wherein a mass percentage of the colorant in the resin composition does not exceed 1%, and a mass percentage of the toughening agent in the resin composition does not exceed 15%.

11. The resin composition according to any one of claims 1 to 10, wherein the colorant comprises one or more of carbon black, carbon microspheres, graphene, and an organic dye.

12. The resin composition according to any one of claims 1 to 11, wherein the resin composition further comprises an ion trapping agent whose mass percentage does not exceed 2%.

13. The resin composition according to any one of claims 1 to 12, wherein the curing agent is an anhydride curing agent.

14. The resin composition according to claim 13, wherein the anhydride curing agent comprises one or more of methylhexahydrophthalic anhydride, methyltetrahydrophthalic anhydride, methyl nadic anhydride, hydrogenated methyl nadic anhydride, dodecenyl succinic anhydride, and terpenic anhydride.

15. The resin composition according to any one of claims 1 to 14, wherein the epoxy resin comprises at least epoxy resin that is in a liquid state at the room temperature.

16. The resin composition according to any one of claims 1 to 15, wherein the resin composition is black.

17. A preparation method of a resin composition, comprising the following steps:
first dispersing an auxiliary agent and a curing accelerator in epoxy resin, and then adding a curing agent to obtain a resin composition, wherein the auxiliary agent comprises a colorant and a toughening agent, and a total mass fraction of particles with particle sizes greater than 300 nm in the resin composition is less than or equal to 0.1 wt%.

18. An application of the resin composition according to any one of claims 1 to 16 in sealed packaging of an electronic component.

19. A packaging material, used for sealed packaging of an electronic component, wherein the packaging material comprises the resin composition according to any one of claims 1 to 16 and/or a cured product of the resin composition.

20. A cured product, wherein the cured product comprises a cured product of the resin composition according to any one of claims 1 to 16, or the cured product is obtained by curing a resin composition prepared by using the preparation method according to claim 17.

21. A package, wherein the package comprises the cured product according to claim 20.

22. A package, wherein the package comprises a substrate and a chip disposed on the substrate, a plurality of solder bumps are provided on a surface that is of the chip and that faces a side of the substrate, an underfill layer is disposed between the solder bumps, and the underfill layer comprises the cured product according to claim 20.

23. A display, wherein the display comprises a display panel and the package according to claim 22 connected to the display panel.

24. An electronic device, wherein the electronic device comprises the package according to claim 21 or the display according to claim 23.
